# EUROPÄISCHE PATENTSCHRIFT

(11) **EP 0 996 985 B1**
(45) Veröffentlichungstag und Bekanntmachung des Hinweises auf die Patenterteilung: **03.12.2003**
(21) Anmeldenummer: 98944975.6
(22) Anmeldetag: 09.07.1998
(51) Int. Cl.: H01L 33/00, H01L 29/45

(54) **II-VI-HALBLEITERBAUELEMENT MIT MINDESTENS EINEM ÜBERGANG VON EINER Se-ENTHALTENDEN SCHICHT AUF EINE BeTe-ENTHALTENDE SCHICHT UND VERFAHREN ZUM HERSTELLEN DES ÜBERGANGES**
II-VI SEMICONDUCTOR COMPONENT WITH AT LEAST ONE JUNCTION BETWEEN AN Se-CONTAINING LAYER AND A BeTe CONTAINING LAYER AND METHOD FOR PRODUCING SAID JUNCTION
COMPOSANT A SEMI-CONDUCTEUR II-VI COMPORTANT AU MOINS UNE JONCTION ENTRE UNE COUCHE CONTENANT DU Se ET UNE COUCHE CONTENANT DU BeTe PROCEDE PERMETTANT DE REALISER LA JONCTION

(30) Priorität: 09.07.1997 DE 19729396
(43) Veröffentlichungstag der Anmeldung: 03.05.2000
(73) Patentinhaber: Osram Opto Semiconductors GmbH & Co. OHG, 93049 Regensburg (DE)
(72) Erfinder: FISCHER, Frank, D-97074 Würzburg (DE); WAAG, Andreas, D-97076 Würzburg (DE); BARON, Thierry, D-97218 Gerbrunn (DE); LANDWEHR, Gottfried, D-97074 Würzburg (DE); LITZ, Thomas, D-97074 Würzburg (DE); REUSCHER, Günter, D-97074 Würzburg (DE); KEIM, Markus, D-97072 Würzburg (DE); ZEHNDER, Ulrich, D-97074 Würzburg (DE); STEINRÜCK, Hans-Peter, D-91056 Erlangen (DE); NAGELSTRASSER, Mario, D-97074 Würzburg (DE); LUGAUER, Hans-Jürgen, D-97218 Gerbrunn (DE)
(74) Vertreter: Epping, Wilhelm, Dipl.-Ing.
(86) Internationale Anmeldenummer: DE9801913
(87) Internationale Veröffentlichungsnummer: WO99003156

(56) Entgegenhaltungen:
- EP-A- 0 632 504
- DE-A- 19 542 241
- FISCHER F ET AL: "II-VI light-emitting devices based on beryllium chalcogenides" JOURNAL OF CRYSTAL GROWTH, Bd. 175-176, Nr. 3001, Mai 1997, Seite 532-540 XP004088843
- PATENT ABSTRACTS OF JAPAN vol. 095, no. 008, 29. September 1995 & JP 07 135339 A (SONY CORP), 23. Mai 1995
- CHEN W ET AL: "REDUCTION OF THE AU/P-ZNSE(100) SCHOTTKY BARRIER HEIGHT USING A THIN SE INTERLAYER" JOURNAL OF CRYSTAL GROWTH, Bd. 138, Nr. 1/04, 2. April 1994, Seite 1078 XP000474568

## Beschreibung

Die vorliegende Erfindung bezieht sich auf ein II-VI-Halbleiterbauelement mit mindestens einem Übergang von einer Se-enthaltenden Schicht auf eine BeTe-enthaltenden Schicht und Verfahren zum Herstellen des Überganges.
Sie bezieht sich insbesondere auf einen verlustarmen Kontakt zu einem p-leitenden Mischkristall basierend auf II-VI-Halbleitermaterialien wie beispielsweise ZnSe.

Für die Herstellung elektrischer Kontakte auf II-VI-Halbleiter-Bauelementen werden verschiedene Verfahren eingesetzt. Insbesondere für derartige Bauelemente aus Mischkristallen auf der Basis von ZnSe ergeben sich hierbei erhebliche Schwierigkeiten.

Bei der Herstellung von Kontakten auf p-leitendem ZnSe erwies es sich als ungeeignet, einen einfachen Metallkontakt einzusetzen, da aufgrund der sehr hohen Valenzbandaffinität von ZnSe stets eine hohe Schottky-Barriere am Metall/p-Halbleiter-Übergang ausgebildet wird, die nur schwer von positiven Ladungsträgern durchtunnelt werden kann.

Der Tunneleffekt kann verstärkt werden, indem die Dotierung des p-ZnSe durch sehr niedrige Wachstumstemperaturen erhöht und die Potentialbarriere dadurch geschmälert wird (man vgl. J. Qiu et al., Journal of Crystal Growth 12 (1993), S. 279ff). Andere Versuche, die Leitfähigkeit über den p-Kontakt auf ZnSe zu erhöhen, bedienen sich einer hochleitfähigen HgSe-Schicht, die zwischen den Metallkontakt und das p-ZnSe eingebracht wird (man vgl. Y. Lansari et al., Applied Physics Letters 61 (1992), Seite 2554ff).

Eine erhöhte Randdotierung kann auch durch eine oberflächennahe p-ZnTe-Schicht erfolgen, welche darüber hinaus eine geringere Valenzbandaffinität (entspricht höherer Valenzbandenergie) als ZnSe besitzt. Demzufolge bildet sich eine flachere Schottky-Barriere, welche bei hohen Akzeptorkonzentrationen leichter von Löchern überwunden werden kann.

Die Absenkung der Valenzbandaffinität an der Oberfläche zur Verbesserung der ohmschen Kontakteigenschaften stößt auf das Problem, daß durch die unterschiedliche Valenzbandaffinität der Bauelementdeckschicht, die beispielsweise auf ZnSe basiert, und der oberflächlichen Kontaktschicht, die beispielsweise aus ZnTe oder BeTe besteht, eine Barriere für Löcher im Halbleiterkörper entsteht, die den Transport durch die Halbleiterkontaktstruktur erschwert.

Bekannt ist, daß die Valenzbanddiskontinuität von isovalenten Grenzflächen, beispielsweise von ZnSe/ZnTe oder GaAs/AlAs, in nur geringem Maße beeinflußt werden kann (man vgl. R.G. Dandrea, C. B.Duke, Journal of Vacuum Science and Technology B 10(4) (1992), Seite 1744). Bislang ist demnach keine Methode bekannt, wie die Banddiskontinuität an einem Übergang wie beispielsweise von ZnTe nach ZnSe oder von BeTe nach ZnSe abgebaut und damit der Ladungsträgertransport erleichtert werden kann. Mit der großen Valenzbanddiskontinuität zwischen BeTe und ZnSe von ca. 1,2 eV oder zwischen ZnTe und ZnSe von ca. 0,8 eV ist es nicht möglich, Verfahren zur Überwindung der Potentialbarriere einzusetzen, wie sie beispielsweise bei F. Capasso et al., Journal of Vacuum Science and Technology B 3(4) (1985), Seiten 1245 bis 1251 oder bei H.J. Gossmann et al., Critical Reviews in Solid State and Materials Science 18(1) (1993), Seiten 1 bis 67 beschrieben sind.

Aus diesem Grund wurden Kontaktschichtfolgen vorgeschlagen, bei welchen die Valenzbandenergie nahe der Oberfläche durch Aufbringen von Halbleitervielfachschichten allmählich erhöht wird, so daß der Valenzbandkantensprung abgeflacht und die Löcherbarriere zwischen ZnSe und ZnTe bzw. zwischen ZnSe und BeTe erniedrigt wird. Beispielsweise wurde vorgeschlagen, ZnSe/ZnTe-Vielfachschichten zu verwenden, wodurch die Valenzbandenergie des ZnSe innerhalb einer oberflächennahen Zone auf die Valenzbandenergie von ZnTe angehoben wird und so ein Kontakt mit geringer Schottky-Barriere erzeugt werden kann, der niederohmig ist, zumal ZnTe hoch p-leitend hergestellt werden kann (man vgl. WO94/15369 und Y. Fan et al., Applied Physics Letters 61 (1992), Seite 3161ff). Dieser Aufbau wird in der Literatur "Grading" oder "Pseudograding" genannt. Eine ähnliche Kontaktstruktur bezieht das Material BeTe an Stelle von ZnTe in BeTe/ZnSe Vielfachschichten als p-Kontakt ein, wie es in WO94/15369, in P.M. Mensz, Applied Physic Letters 64(16) (1994), Seite 2148 oder in US 5,422,902 beschrieben ist. Hierbei wird eine erhöhte kristalline Qualität der Kontaktschicht erwartet, wodurch für den Betrieb eines Bauelementes schädliche Gitterdefekte ausbleiben. Mit der Möglichkeit, gitterangepaßte BeTe/ZnSe "Pseudograding"-Heterostrukturkontakte in guter struktureller Qualität zu erzeugen, kann der p-leitende elektrische Anschluß an ein II-VI-Bauelement auch an die Grenzfläche zu einem p-leitenden Substrat gelegt werden, wie es in WO94/15369 behandelt ist.

Der beschriebene Pseudograding-Kontakt hat einen komplizierten Aufbau mit vielen internen Grenzflächen. Er besteht aus einer Vielfachschicht, in welcher BeTe und ZnSe sich abwechseln, wobei die Schichtdickenanteile der beiden Komponenten graduell geändert werden. Die gesamte Dicke der ZnSe/BeTe Kontaktschichtfolge beträgt zwischen 200 Å und 1000 Å (man vgl. P.M. Mensz, Applied Physic Letters 64(16) (1994), Seite 2148 oder US 5,422,902). Innerhalb dieser Länge wird die mittlere Konzentration an BeTe von 0 auf 100% schrittweise durch Erhöhung der BeTe-Schichtdicke bei gleichzeitiger Verringerung der ZnSe-Schichtdicke eingestellt. Der Gesamtwiderstand der BeTe/ZnSe Kontaktstruktur liegt bei üblichen Herstellungsparametern von BeTe und ZnSe in einem Bereich von 10⁻²-10⁻³ Ωcm² und bedeutet damit zu hohe elektrische Verluste in der Kontaktstruktur. Der hohe Widerstand wird auf die große Valenzbanddiskontinuität zwischen BeTe und ZnSe zurückgeführt, die bei 1,21 eV liegt.

Bei den genannten Kontaktstrukturen mit ZnSe/ZnTe bzw. ZnSe/BeTe Vielfachschichten (Pseudograding) liegt ein weiteres Problem darin, daß bei hohen Konzentrationen des Dotierstoffes Stickstoff viele Gitterfehlstellen erzeugt werden, die eine Interdiffusion der Übergitter-Matrixelemente und des Dotierstoffes ermöglichen. Solche Fehlstellen können auch agglomerieren und ausgedehnte Gitterdefekte im Kontakt erzeugen, wodurch der Betrieb einer Laserdiode stark gestört und die Lebensdauer somit reduziert werden kann.

Ein weiteres Problem des BeTe/ZnSe Peudograding-Kontaktes besteht darin, daß es bei den verwendeten Schichtdicken zu einer Welligkeit der Grenzflächen zwischen BeTe und ZnSe kommt, die sich einstellt, um elastische Verspannungen zu erniedrigen. Diese Unebenheit wirkt sich ebenfalls negativ auf die Funktion einer Laserdiode aus.

Der Übergang von Löchern aus dem Valenzband von beispielsweise BeTe in das Valenzband von ZnSe tritt nicht nur in Kontaktstrukturen auf, sondern ist beispielsweise auch in vertikal emittierenden Lasern mit BeTe- und ZnSe-enthaltenden Bragg-Reflektoren relevant. Für derartige Bauelementstrukturen ist die Verwendung eines ausgedehnten Gradings oder Pseudogradings sehr nachteilig.

Die Aufgabe der vorliegenden Erfindung besteht darin, einen verbesserten Übergang von einer Se-enthaltenden Schicht, insbesondere von einer ZnSe-enthaltenden Schicht, auf eine BeTe-enthaltende Schicht zu entwickeln. Weiterhin soll ein einfaches Verfahren zum reproduzierbaren Herstellen des Überganges angegeben werden.

Es soll insbesondere ein Kontakt angegeben werden, bei dem die Valenzbanddiskontinuität an einer Grenzfläche zwischen einer BeTe- und einer ZnSe-enthaltenden Schicht stark reduziert und so ein verlustarmer Übergang von Löchern aus der BeTe- in die ZnSe-entheltende Schicht, insbesondere von p-leitenden Schichten, erzeugt werden kann. Im Speziellen sollen Kontaktstrukturen zu Verfügung gestellt werden, mit welchen ein verlustarmer p-Kontakt zu p-leitenden II-VI Halbleiterschichten, die ZnSe enthalten, erzeugt werden kann.

Unter BeTe-enthaltenden Materialien werden im folgenden Materialien verstanden, wie beispielsweise BeₓMg_{y}Zn_{1-x-y}Te, BeₓCd_{y}Zn_{1-x-y}Te, BeₓMg_{y}Cd_{1-x-y}Te, BeₓMn_{y}Zn_{1-x-y}Te, BeₓSr_{y}Zn_{1-x-y}Te, BeₓBa_{y}Zn_{1-x-y}Te (0<=x<=1, 0<=y<=1, x+y<=1) oder andere Mischkristalle, die Be und Te enthalten.
Unter ZnSe-enthaltenden Materialien werden im folgenden Materialien verstanden, wie beispielsweise BeₓMg_{y}Zn_{1-x-y}Se, BeₓCd_{y}Zn_{1-x-y}Se, BeₓMg_{y}Cd_{1-x-y}Se, BeₓMn_{y}Zn_{1-x-y}Se, BeₓSr_{y}Zn_{1-x-y}Se, BeₓBa_{y}Zn_{1-x-y}Se(0<=x<=1, 0<=y<=1, x+y<=1) oder ZnₓMg₁₋ₓS_{y}Se_{1-y} oder BeₓZn₁₋ₓS_{y}Se_{1-y} (0<=x<=1, 0<=y<=1) oder andere Mischkristalle, die Zn und Se enthalten.

Die oben genannte Aufgabe wird mit einem II-VI-Halbleiterbauelement gelöst, das die Merkmale des Patentanspruches 1 aufweist. Vorteilhafte Weiterbildungen sind Gegenstand der Unteransprüche 2 bis 8. Bevorzugte Verfahren zur Herstellung des II-VI-Halbleiterbauelements sind Gegenstand der Ansprüche 9 bis 11.

Erfindungsgemäß ist vorgesehen, daß innerhalb einer Schichtenfolge, z. B. einer Kontaktzone, auf einer aktiven Schichtfolge eines optoelektronischen II-VI-Halbleiterbauelements (lichtemittierend oder lichtempfangend) mindestens eine BeTe-enthaltende Halbleiterschicht auf mindestens einer Se insbesondere ZnSe-enthaltenden Halbleiterschicht bzw. mindestens eine Se-enthaltende Halbleiterschicht auf mindestens einer BeTe-enthaltende Halbleiterschichten epitaktisch (z. B. mittels MBE oder MOCVD) aufgebracht ist und daß eine Grenzfläche zwischen der BeTe-enthaltenden und der ZnSe-enthaltenden Halbleiterschicht, insbesondere durch Einbringen einer Se-reichen Zwischenschicht, so präpariert ist, daß eine Be-Se-Konfiguration ausgebildet ist, die eine Potentialbarriere (Valenzbanddiskontinuität) für Löcher von weniger als 1,2 eV darstellt.

Diese Grenzflächenkonfiguration wird erfindungsgemäß dadurch erzeugt, daß beim epitaktischen Wachstum von ZnSe immer mit einer Se-Bedeckung aufgehört bzw. begonnen wird und/oder das Wachstum von ZnSe unter Se-reichen Bedingungen erfolgt.

Bei einem bevorzugten Verfahren der erfindungsgemäßen Grenzflächenpräparation wird die Konfiguration an der Grenzfläche dadurch erzielt, daß nach dem Wachstum einer ZnSe-Schicht und vor dem Wachstum einer BeTe-Schicht auf die Oberfläche dieser ZnSe-Schicht z. B. für 0,5 bis 60 Sekunden ein Se-Fluß mit einem Strahl-äquivalenten Druck zwischen 1×10⁻⁵ und 1×10⁻⁸ Torr gegeben wird. Die Substrattemperatur liegt hierbei zwischen 150°C und 350°C, bevorzugt jedoch zwischen 200°C und 250°C.

Nach der Se-Stabilisierung der Oberfläche kann sich eine Wachstumspause von bis zu 20 Sekunden anschließen, die bevorzugt weniger als 5 Sekunden beträgt oder auch weggelassen werden kann.

Auf die dadurch hergestellte Se-stabilisierte ZnSe/Se-Oberfläche, die an einer deutlichen (2x1)-Rekonstruktion der Oberfläche in RHEED-Messungen identifiziert werden kann (von Reflection High Energy Electron Diffraction), wird die BeTe-Schicht aufgebracht, in der Art, daß beim Wachstum der BeTe-Schicht das Flußverhältnis zwischen Te und Be zwischen 2 und 50 beträgt, bevorzugt wird ein Te:Be-Verhältnis von 2 bis 10 eingestellt. Nach dem Wachstum von BeTe wird eine Wachstumsunterbrechung von 0 bis 180 Sekunden, bevorzugt zwischen 1 und 10 Sekunden, eingelegt. Dabei wird die Substrattemperatur bei der Wachstumstemperatur von ZnSe bei 200°C bis 250°C gehalten, sie kann aber auch auf bis zu 550°C erhöht werden.

Nach der Wachstumsunterbrechung wird bei Substrattemperaturen zwischen 150°C und 350°C für 0 bis 180 Sekunden Se auf die Oberfläche gegeben. Auf einer derart präparierten BeTe/Se-Oberfläche kann wieder das Wachstum von ZnSe gestartet werden.

In einer weiteren bevorzugten Variante der erfindungsgemäßen Methode wird die Be-Se-Konfiguration der Grenzfläche dadurch präpariert, daß das Wachstum von ZnSe unter Überschuß an Se stattfindet (Se:Zn Verhältnis 1,1:1 bis 5:1), bevorzugt bei Substrattemperaturen zwischen 150°C und 350°C. Vorteilhaft hierbei ist, wenn die Wachstumsrate von ZnSe zwischen 0,1 und 1 Monolage beträgt. Unter derartigen Wachstumsbedingungen stellt sich eine deutliche (2x1)-Rekonstruktion an der ZnSe-Oberfläche ein. Hierbei muß an den Grenzflächen nicht notwendigerweise eine Wachstumsunterbrechung eingelegt werden.

Bei den beschriebenen Verfahren wird erreicht, daß sich an der Grenzfläche zwischen BeTe und ZnSe eine Bindung zwischen Be und Se ausbildet, nicht aber zwischen Zn und Te. Hierbei wird ausgenützt, daß Te-Atome, die sich in einem gebundenen Zustand auf der Oberfläche von BeTe befinden, von Se-Atomen verdrängt werden. Umgekehrt findet die Verdrängung von Se durch Te auf der ZnSe-Oberfläche nicht statt.
Der Vorteil der Grenzfläche mit Be-Se Konfiguration liegt darin, daß die Valenzbanddiskontinuität zwischen BeTe-enthaltenden Schichten und ZnSe-enthaltenden Schichten von über 1,2 eV auf ca. 0,4 eV verringert ist. Diese verbleibende Potentialbarriere für Löcher im Valenzband kann in neuen Kontaktstrukturen aus beispielsweise BeTe und ZnSe durch gezielte Dotierung mit Akzeptoren und Donatoren weiter reduziert werden.

Die erfindungsgemäße Kontaktstruktur ist insbesondere vorgesehen für ein optoelektronisches Bauelement auf einem Substrat aus einem Material der Gruppe von GaAs, InAs, In-GaAs, GaP, InP, Si, Ge, ZnO, ZnSe, ZnTe, CdTe, ZnCdTe mit einer für Strahlungserzeugung vorgesehenen aktiven Schicht, bei dem die aktive Schicht als Quantentrog oder Übergitter mit vorgegebener Periode oder Mehrfachquantentrog oder Quantenpunktstruktur ausgebildet ist, bei dem die aktive Schicht zwischen Schichten angeordnet ist, die für elektrische Leitfähigkeit mit zueinander entgegengesetztem Vorzeichen dotiert sind, und bei dem elektrische Kontakte vorhanden sind, welche aus einer Folge von Selen-enthaltenden Materialien und BeTe-enthaltenden Schichten bestehen und in der Kontaktschichtfolge eine Grenzfläche zwischen zu diesen Materialgruppen gehörenden Schichten existiert und diese Grenzfläche derart präpariert ist, daß sich am Materialübergang eine Grenzflächenkonstellation mit einer Valenzbanddiskontinuität von weniger als 1,2 eV ergeben würde.

Das ZnSe-enthaltende Material ist hierbei bevorzugt aus der Gruppe BeₓMg_{y}Zn_{1-x-y}Se, BeₓCd_{y}Zn_{1-x-y}Se,
BeₓMg_{y}Cd_{1-x-y}Se, BeₓMn_{y}Zn_{1-x-y}Se, BeₓSr_{y}Zn_{1-x-y}Se,
BeₓBa_{y}Zn_{1-x-y}Se(0<=x<=1, 0<=y<=1, x+y<=1), ZnₓMg₁₋ₓS_{y}Se_{1-y},
BeₓZn₁₋ₓS_{y}Se_{1-y} (0<=x<=1, 0<=y<=1) und das BeTe-enthaltende Schicht aus der Gruppe BeₓMg_{y}Zn_{1-x-y}Te, BeₓCd_{y}Zn_{1-x-y}Te, BeₓMg_{y}Cd_{1-x-y}Te, BeₓMn_{y}Zn_{1-x-y}Te, BeₓSr_{y}Zn_{1-x-y}Te, BeₓBa_{y}Zn_{1-x-y}Te (0<=x<=1, 0<=y<=1, x+y<=1), BeₓZn₁₋ₓS_{y}Te_{1-y} (0<=x<=1, 0<=y<=1), BeₓCd₁₋ₓS_{y}Te_{1-y} (0<=x<=1, 0<=y<=1) .

Die Grenzflächenkonstellation mit geringem Valenzbandoffset ist eine Be-Se-Konfiguration an der Grenzfläche. Diese ist bevorzugt dadurch gebildet, daß bei der Herstellung der Halbleiterschichten an der gebildeten Grenzfläche eine Bedeckung der ZnSe-enthaltenden Schichten und/oder BeTe-enthaltenden Schichten mit Selen aus einem Selenteilchenfluß erfolgt.

Bei einer Weiterbildung ist in einem Abstand d zur Grenzfläche zwischen der BeTe-enthaltenden Schicht und der ZnSe-enthaltenden Schicht in der ZnSe-enthaltenden Schicht mindestens eine Schicht mit erhöhter Akzeptorkonzentration eingefügt. Der Abstand d ist bevorzugt kleiner als 4 nm.

Eine Schicht mit erhöhter Flächenladungsdichte kann Tellur oder BeTe enhalten. Jede Schicht mit erhöhter Flächenladungsdichte ist z. B. zwischen 0,5 Monolagen und fünf Monolagen dick. Anstelle der BeTe-enthaltenden Schicht kann ein Metallkontakt direkt auf der ZnSe-enthaltenden Schicht aufgebracht sein. In einem Abstand d₁ von der Grenzfläche kann in der ZnSe-enthaltenden Schicht eine Schicht mit erhöhter Akzeptorkonzentration und im Abstand d₂ zur Grenzfläche in der BeTe-enthaltenden Schicht eine Schicht mit Donatoren eingebracht sein. Die Abstände d1 und d2 können unterschiedlich groß oder gleichgroß sein. Die Akzeptorkonzentration bzw. Donatorkonzentration in den hochdotierten Schichten können unterschiedlich oder gleich groß sein. Der Abstand d1+d2 beträgt beispielsweise zwischen 0,5 nm und 30 nm. Die Höhe der Flächenladungsdichten in den hochdotierten Schichten kann größer als 10¹²cm⁻³ sein und die Dicke der hochdotierten Schichten beträgt beispielsweise nicht mehr als 50 Monolagen. Der mit Donatoren dotierte Bereich enthält z. B. Selen oder ZnSe. Als Donator-Dottierstoff kann Al, Cl, Br oder Iod verwendet sein. Der mit Akzeptoren hochdotierte Bereich enthält z. B. Te oder BeTe, und als Akzeptor-Dotierstoff ist z. B. N, As, Sb, P oder ein anderes Element der I., IV. oder V. Hauptgruppe verwendet.

Zwischen einer ZnSe-enthaltenden Schicht und einer BeTe-enthaltenden Schicht kann eine Übergangsschicht eingebracht sein, die aus einer Legierung mit gradueller Änderung der Zusammensetzung besteht.

Alle ZnSe und BeTe-enthaltenden Schichten können p-leitend dotiert sein. Die Legierung kann als digitale Legierung ausgebildet sein. Die Variation der Zusammensetzung der graduellen oder digitalen graduellen Legierung ist linear oder nicht linear. Zwischen der ZnSe-enthaltenden Schicht und der graduellen bzw. digitalen graduellen Legierung kann mindestens eine delta-dotierte Schicht mit erhöhter Akzeptorkonzentration eingefügt sein. Zwischen der graduellen bzw. digitalen graduellen Legierung und der BeTe-enthaltenden Schicht kann mindestens eine delta-dotierte Schicht mit Donatoren eingebracht sein. Als Donator-Dotierstoff kann Al, Cl, Br oder I verwendet sein. Die delta-dotierten Schichten sind beispielsweise zwischen 0,5 und 50 Monolagen dick. Die Flächenladungsdichte in den mit Akzeptoren bzw. Donatoren delta-dotierten Schichten kann gleich groß sein und in Abhängigkeit vom Abstand der delta-dotierten Schichten so eingestellt sein, daß das sich aufbauende interne elektrische Feld des Dotierungsdipols den Potentialgradienten innerhalb der graduellen oder digitalen graduellen Legierung kompensiert. Der Abstand der delta-dotierten Schichten ist beispielsweise kleiner als 30 nm.

Im folgenden wird die erfindungsgemäße Kontaktstruktur und deren Herstellungsverfahren anhand von Ausführungsbeispielen in Verbindung mit den Figuren 1 bis 15 näher erläutert. Es zeigen
Figur 1 eine schematische Darstellung einer BeTe/ZnSe-Grenzfläche mit einer Be-Se Konfiguration,
Figur 2 eine vereinfachte Darstellung des Bänderschemas für einen BeTe/ZnSe-Übergang mit Be-Se-Grenzflächenkonfiguration,
Figur 3 eine schematische Darstellung einer BeTe/ZnSe-Grenzfläche mit einer Zn-Te Konfigurationen,
Figur 4 eine vereinfachte Darstellung des Bänderschemas für einen BeTe/ZnSe-Übergang mit Zn-Te-Grenzflächenkonfiguration,
Figur 5 eine schematische Darstellung des Schichtaufbaus einer erfindungsgemäßen Kontaktstruktur mit gradueller Legierung (Figur 5a) und eine schematische Darstellung des Schichtaufbaus einer erfindungsgemäßen Kontaktstruktur mit gradueller digitaler Legierung (Figur 5b),
Figur 6 eine vereinfachte Darstellung des Bänderschemas im Bereich der Übergangsschicht mit gradueller oder gradueller digitaler Legierung ohne Berücksichtigung von dotierten Bereichen (Figur 6a) und die vereinfachte Darstellung des Bänderschemas im Bereich der Übergangsschicht mit gradueller oder gradueller digitaler Legierung unter Berücksichtigung eines internen elektrischen Feldes durch Einbringen eines Dotierungsdipols in Form dünner, gegensätzlich dotierter Bereiche (Figur 6b),
Figur 7 die Abhängigkeit der Flächenladungsdichte von der Weite der graduellen Legierung, wie sie in Figur 5a und 5b verwendet ist,
Figur 8 eine schematische Darstellung des Schichtaufbaus mit Dotierungsdipol nahe der Grenzfläche,
Figur 9 eine vereinfachte Darstellung des Bänderschemas im Bereich der Grenzfläche zwischen einer BeTe-enthaltenden Schicht und einer ZnSe-enthaltenden Schicht ohne Berücksichtigung von Dotierung (Flachbandfall in Figur 9a) und die vereinfachte Darstellung des Bänderschemas im Bereich der Grenzfläche unter Berücksichtigung eines internen elektrischen Feldes durch Einbringen eines Dotierungsdipols in Form dünner, gegensätzlich dotierter Bereiche (Figur 9b),
Figur 10 die benötigte Flächenladungsdichte als Funktion der Reduktion der Potentialbarriere für verschiedene Abstände des Dotierungsdipols,
Figur 11 eine schematische Darstellung des Schichtaufbaus einer erfindungsgemäßen Kontaktstruktur mit δ-dotiertem Bereich nahe der Grenzfläche zu einem Metallkontakt (Figur 11a) und eine schematische Darstellung des Schichtaufbaus einer erfindungsgemäßen Kontaktstruktur mit δ-dotiertem Bereich nahe der Grenzfläche zwischen einem BeTe-enthaltenden Material und einem ZnSe-enthaltenden Material (Figur 11b),
Figur 12 eine vereinfachte Darstellung des Bänderschemas im Bereich eines Metall/Halbleiter-Überganges unter Berücksichtigung einer δ-dotierten Schicht nahe der Grenzfläche (Figur 12a) und die vereinfachte Darstellung des Bänderschemas im im Bereich eines Halbleiter/Halbleiter-Überganges unter Berücksichtigung einer δ-dotierten Schicht nahe der Grenzfläche (Figur 12b),
Figur 13 die Abhängigkeit der Flächenladungsdichte vom Abstand d der δ-dotierten Schicht von der Grenzfläche zwischen einem BeTe-enthaltenden und einem ZnSe-enthaltenden Material, wie sie in Figur 11b auftritt, und eine Abschätzung für die erzielbaren Kontaktwiderstände für verschieden Werte der Valenzbanddiskontinuität,
Figur 14 eine schematische Darstellung des Schichtaufbaus einer Leucht- oder Laserdiode mit erfindungsgemäßer Kontaktstruktur auf der dem Substrat abgewandten Seite der aktiven Zone,
Figur 15 eine schematische Darstellung des Schichtaufbaus einer Leucht- oder Laserdiode mit erfindungsgemäßer Kontaktstruktur, die auf der dem Substrat zugewandten Seite der aktiven Zone angeordnet ist.

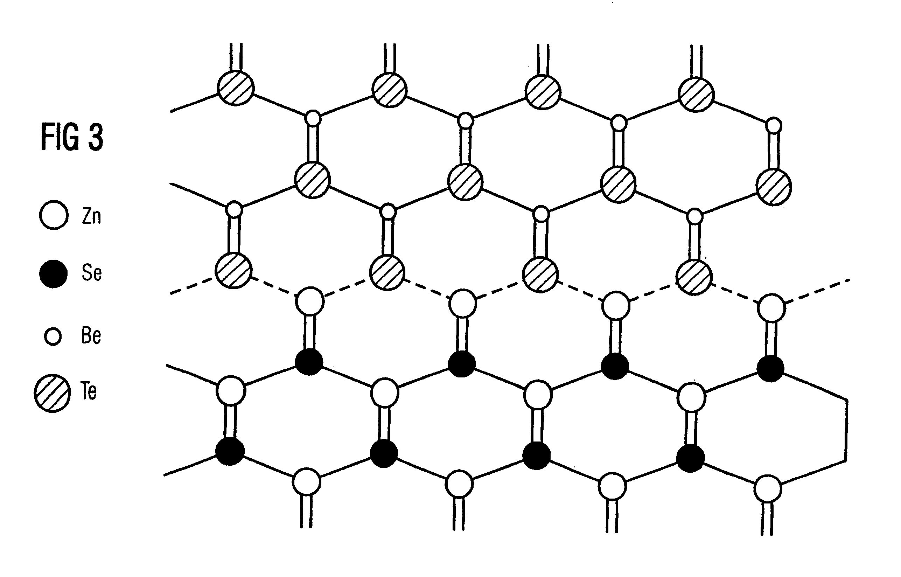

Die in Figur 3 gezeigte Projektion eines Zinkblendekristallgitters ist eine schematische Darstellung der Grenzfläche zwischen ZnSe und BeTe, wie sie sich einstellt, wenn auf einer Zn-bedeckten ZnSe-Schicht eine BeTe-enthaltende Schicht aufgebracht wird. Die Zn-Te Konfiguration der Grenzfläche ist durch gestrichelte Bindungsarme symbolisiert. Diese Konfiguration kann durch gezielte Zn-Oberflächenbedeckung der unterliegenden ZnSe-Schicht erzeugt werden oder sie stellt sich ein, wenn ZnSe unter Zn-reichen Wachstumsbedingungen hergestellt und darauf BeTe abgeschieden wird. Die Bildung dieser Grenzfläche kann daran erkannt werden, daß die ZnSe-Oberfläche vor dem Aufbringen von BeTe eine c(2x2)-Rekonstruktion in der RHEED-Messung aufweist. Bei der umgekehrten Reihenfolge (ZnSe auf BeTe) kann diese Konfiguration erzielt werden, wenn das Wachstum von ZnSe auf BeTe mit Tereicher Oberfläche zuerst mit einer Zn-Bedeckung der Oberfläche beginnt oder wiederum Zn-reiche Bedingungen in den Molekularstrahlen herrschen.

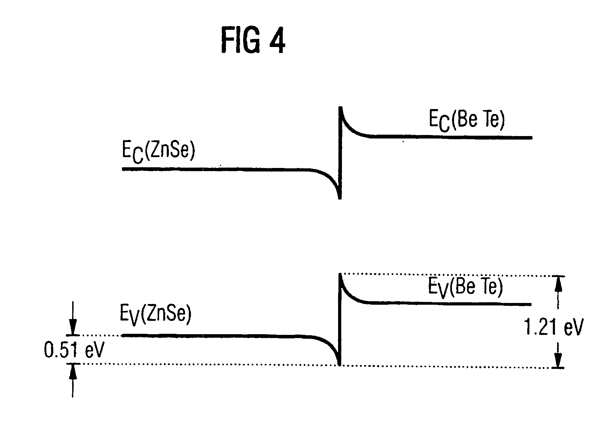

An einer derartigen Grenzfläche ergibt sich eine energetische Barriere für positive Ladungsträger (Löcher) beim Übergang von BeTe in ZnSe von ca. 1,21 eV , wie es in Figur 4 gezeigt ist. Dieser Wert wurde mit UPS (UV Photoelektronen Spektroskopie) an einem nach dem oben angegebenen Verfahren präparierten Übergang ZnSe/BeTe bestimmt.

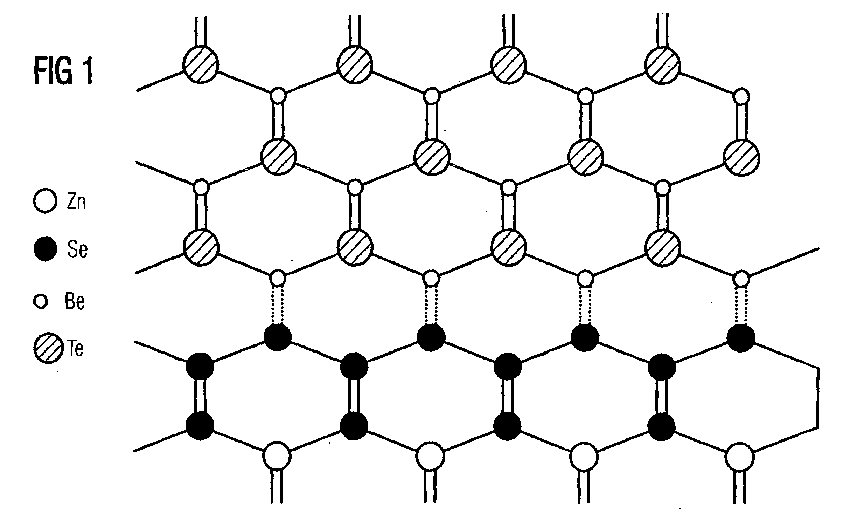

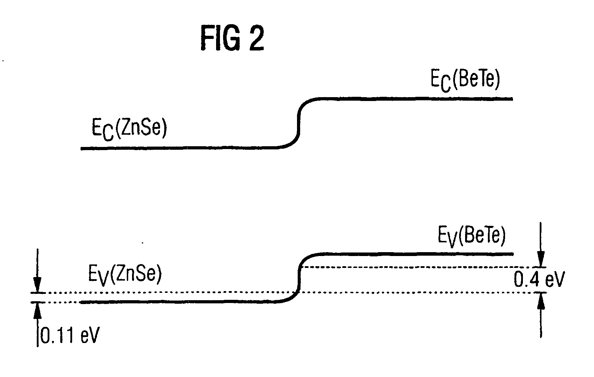

Die in Figur 1 gezeigte Projektion eines Zinkblendekristallgitters auf die {110}-Ebene ist eine schematische Darstellung der Grenzfläche zwischen ZnSe und BeTe, wie sie sich einstellt, wenn auf einer Se-bedeckten ZnSe-Schicht eine BeTe-enthaltende Schicht aufgebracht wird. In dieser Darstellung sind Bindungen, die aus der Zeichenebene heraus bzw. hinein ragen, durch einen Doppelstrich gekennzeichnet. Die Be-Se Bindungskonfiguration der Grenzfläche ist durch gestrichelte Bindungsarme symbolisiert. Diese Konfiguration kann durch gezielte Se-Oberflächenbedeckung der unterliegenden ZnSe-Schicht erzeugt werden oder sie stellt sich ein, wenn ZnSe unter Se-reichen Wachstumsbedingungen hergestellt und darauf BeTe abgeschieden wird. Die Bildung dieser Grenzfläche kann daran erkannt werden, daß die ZnSe-Oberfläche vor dem Aufbringen von BeTe eine (2x1)-Rekonstruktion in der RHEED-Messung aufweist. Bei der umgekehrten Reihenfolge (ZnSe auf BeTe) kann diese Konfiguration erzielt werden, wenn das Wachstum von ZnSe auf BeTe unter Se-reichen Bedingungen oder mit einer Se-Bestrahlung vor dem Wachstum begonnen wird. An einer derartigen Grenzfläche ergibt sich eine energetische Barriere für positive Ladungsträger (Löcher) beim Übergang von BeTe in ZnSe von ca. 0,4 eV , wie es in Figur 2 gezeigt ist. Dieser Wert ist deutlich geringer als für die Zn-Te-Konfiguration an der Grenzfläche (Figur 3 und Figur 4). Auf diese Reduzierung der Loch-Barriere zwischen BeTe und ZnSe zielt der erfindungsgemäße Prozeß zur Herstellung von niederohmigen Kontakten zu ZnSe ab, da unter Einbezug von Dotierung im ZnSe und BeTe die verbleibende Barriere von 400 meV sehr leicht von Löchern überwunden werden kann. In einer Kontaktstruktur, in welcher ein Übergang von BeTe auf ZnSe und umgekehrt eingesetzt wird, kann mit der erfindungsgemäßen Grenzflächenpräparation (siehe Diskussion zu Figur 1 und Figur 2) ein geringerer Spannungsabfall erzielt werden, als bei Grenzflächen, die sich unter üblichen Wachstumsbedingungen (z.B. stöchiometrisches Zn:Se-Verhältnis) zwischen BeTe und ZnSe einstellen.

Mit der Reduktion der Valenzbanddiskontinuität zwischen BeTe und ZnSe und der Möglichkeit, BeTe hoch p-leitend und ZnSe hoch n-leitend dotieren zu können, ist der elektrische Übergang von Löchern aus BeTe-enthaltenden Schichten in ZnSe-enthaltende Schichten auf einfache Art und Weise erleichtert.

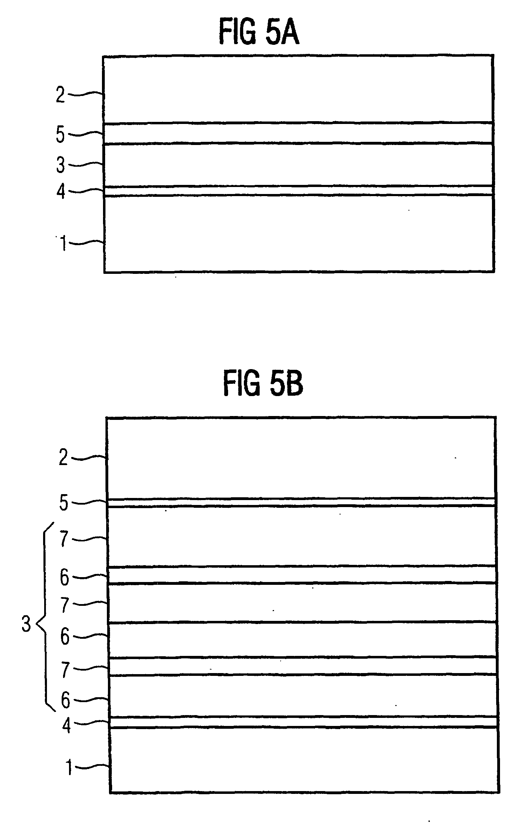

Dies wird erfindungsgemäß z. B. mit einer Schichtfolge erreicht, wie sie in Figur 5a und 5b schematisch dargestellt ist. Hier ist vorgesehen, zwischen einer ZnSe-enthaltenden Schicht 1 und einer BeTe-enthaltenden Schicht 2 eine Übergangsschicht 3 einzubringen. Diese Übergangsschicht kann aus einer Legierung bestehen, deren Zusammensetzung graduell geändert wird, derart, daß die Zusammensetzung der Schicht 3 ausgehend von der Zusammensetzung von Schicht 1 in einer Zone der Weite w graduell auf die Zusammensetzung der Schicht 2 geändert wird, wie es in Figur 5a angedeutet ist. Diese Variation der Zusammensetzung kann auf nichtlineare Weise, bevorzugt jedoch linear graduell erfolgen. Sie kann durch die Änderung der Konzentrationen der Legierungsbestandteile in Schicht 3 erreicht werden.

Erfindungsgemäß ist weiterhin vorgesehen, eine dünne Schicht 4 an der Grenzfläche zwischen der ZnSe-enthaltenden Schicht 1 und der Schicht 3 einzufügen, die eine erhöhte Konzentration an Akzeptoren aufweist. Auf der Seite der graduellen Legierung 3, die an Schicht 2 angrenzt, wird eine dünne Schicht 5 eingefügt, die eine erhöhte Donatorkonzentration aufweist, derart, daß das elektrische Feld, das sich zwischen den ionisierten Akzeptorrümpfen in Schicht 4 und den ionisierten Donatorrümpfen in Schicht 5 aufbaut, den Potentialgradienten innerhalb der graduellen Legierung 3 kompensiert. Die Dicke der δ-dotierten Schichten 4 und 5 kann zwischen 0,5 und 50 Monolagen betragen.

Eine bevorzugte Weise, die Zusammensetzung von Schicht 3 ausgehend von der Zusammensetzung von Schicht 1 auf die Zusammensetzung von Schicht 2 zu ändern, ist in Figur 5b dargestellt und besteht darin, eine sogenannte digitale Legierung zu bilden. In einer digitalen Legierung werden die Konzentrationen der Legierungsbestandteile dadurch eingestellt, daß sehr dünne Schichten verschiedener Materialien aufeinander aufgebracht werden und das Schichtdickenverhältnis die gemittelte Konzentration der Schichtfolge ergibt. Die graduelle Änderung der Zusammensetzung der digitalen Legierung 3 kann durch die allmähliche Änderung des Schichtdickenverhältnisses zwischen den ZnSe-enthaltenden Schichten 6 und BeTe-enthaltenden Schichten 7 in Figur 5b erzielt werden, wie es beispielsweise in einer Pseudograding-Struktur ausgeführt wird.

Das Einbringen der δ-dotierten Bereiche 4 und 5 geschieht in der erfindungsgemäßen Schichtfolge mit digitaler Legierung gemäß Figur 5b durch erhöhte Dotierung der ersten BeTe-enthaltenden Schicht 4 innerhalb der digitalen Legierung 3 mit Akzeptoren (δp). Die erfindungsgemäß mit Donatoren (δn) dotierte Grenzschicht, die an der Grenze zwischen der BeTe-enthaltenden Schicht 2 und der digitalen Legierung 3 liegt, kann durch n-Dotierung der letzten ZnSe-enthaltenden Schicht 5 gebildet werden.

In einer bevorzugten Ausführungsform der erfindungsgemäßen Kontaktstruktur (Figur 5b) beginnt die digitale Legierung 3 aufbauend auf der ZnSe-enthaltenden Schicht 1 mit einer zwei Monolagen dünnen BeTe-enthaltenden Schicht 4, an welche sich eine acht Monolagen dünne ZnSe-enthaltende Schicht 6 anschließt. Durch sukzessive Erhöhung der Dicke der nächsten Schicht 7 um eine Monolage bei gleichzeitiger Erniedrigung der Dicke der darauffolgenden Schicht 6 um eine Monolage, wird das Schichtdickenverhältnis innerhalb der digitalen Legierung 3 mit jedem Schichtpaar 6,7 graduell auf acht Monolagen BeTe-enthaltende Schicht 7 und zwei Monolagen ZnSe-enthaltende Schicht 5 geändert.

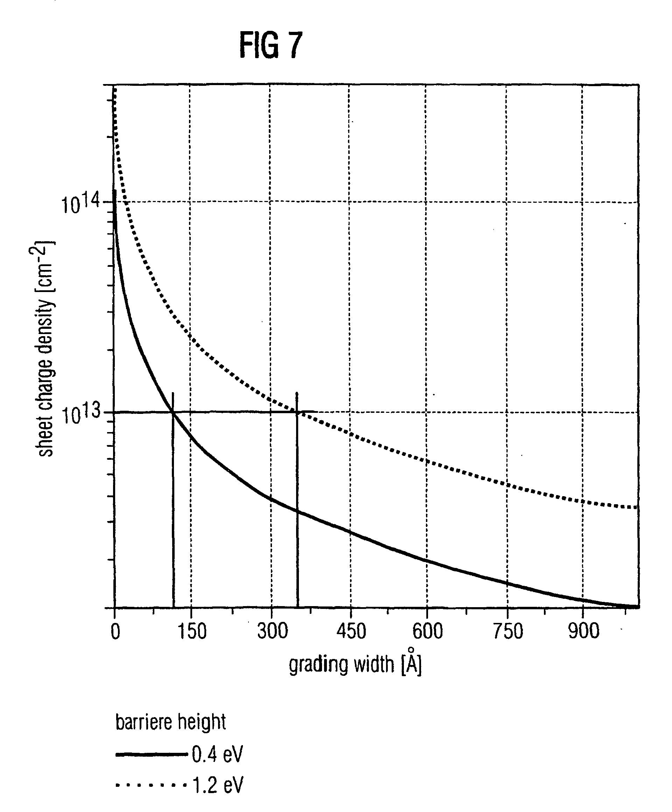

Die einzelnen Schichten 1,6,7 und 2 können p-leitend dotiert sein. Bevorzugt ist, Schicht 1,6 und 2 p-leitend zu dotieren. Zur p-Dotierung kann plasmaaktivierter Stickstoff oder ein anderer Akzeptor aus der I., IV. oder V. Hauptgruppe des Periodensystems verwendet werden. Als Donatoren in Schicht 5 können Al, Cl, Br oder I eingesetzt werden. Die Höhe der Dotierung in Schicht 4 und 5, und damit die Höhe der Grenzflächenladungsdichte wird derart eingestellt, wie es in der Diskussion zu Figur 7 erläutert wird. Auf der BeTe-enthaltenden Schicht kann eine ZnTe-enthaltende Schicht abgeschieden sein, die p-leitend und zwischen 1nm und 500nm dick sein kann, um eine Oxidation der BeTe-enthaltenden Schicht zu unterdrücken.

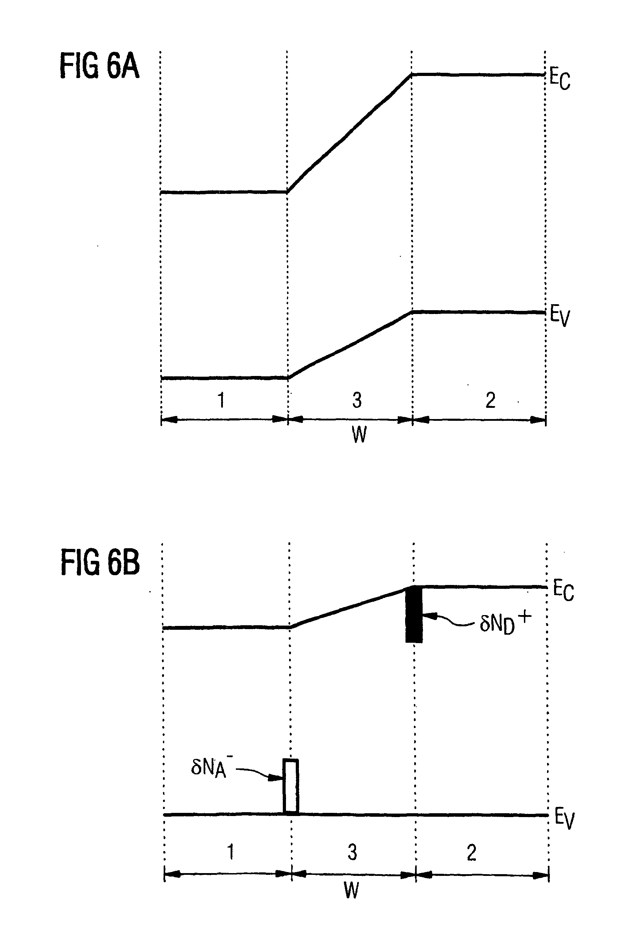

Die Figuren 6a und 6b zeigen schematisch den Verlauf des Valenzbandes E_{V} und des Leitungsbandes E_{C} innerhalb von Halbleiterschichtstrukturen, wie sie in Figur 5a und 5b gezeigt sind. In Figur 6a ist der Verlauf von Valenzband E_{V} und Leitungsband E_{C} dargestellt, wie sie ohne δ-dotierte Bereiche (Schicht 4 und 5 in Figur 5a bzw. 5b) nur durch die graduelle Legierung 3 bestimmt sind. In Figur 6a ist eine Dotierung der Schichten 1,2 und 3 nicht berücksichtigt. In Abbildung 6b ist der Einfluß eines elektrischen Feldes mit einbezogen, das sich zwischen den δ-dotierten Bereichen 4,5 aufbaut, wodurch es bei geeigneter Wahl der Flächenladungsdichte zu einer Eliminierung der Potentialbarriere für Löcher im Valenzband kommt. Dadurch wird der Transport von Löchern aus einer BeTe-enthaltenden Schicht 2 in eine ZnSe-enthaltende Schicht 1 möglich. Unter Annahme gleicher Dotierungshöhen können die Flächenladungsdichten δp und δn, die durch Dotierung in die Grenzschichten 4 und 5 eingebracht werden, in Abhängigkeit von der Weite der graduellen Legierung angegeben werden mit δp=δn=(εΔE_{C})/(e²w), wobei ε die (gemittelte) Dielektrizitätskonstante des Halbleitermaterials ist, ΔE_{C} ist die Höhe der Valenzbanddiskontinuität zwischen Schicht 1 und Schicht 2, e ist die Elementarladung und w die Weite der digitalen Legierung 3. Bei einem nichtlinearen Konzentrationsverlauf innerhalb der graduellen oder digital graduellen Legierung 3 können die Flächenladungsdichten δp und δn auch voneinander abweichen und nicht dem angegebenen Zusammenhang gehorchen. Sie müssen so gewählt werden, daß das sich aufbauende elektrische Feld dem Potentialverlauf in der Schicht 3 entgegenwirkt. Hierzu kann es notwendig sein, mehrere δ-dotierte Bereiche innerhalb der graduellen Legierung einzubringen.

Für eine lineare Variation des Potentials in Schicht 3 ist die Abhängigkeit der Flächenladungsdichte (sheet charge density [cm⁻²]) δp=δn graphisch in Figur 7 für unterschiedliche Barrieren (barrier height) ΔE_{C} im Valenzband (Valenzbanddiskontinuität) zwischen den Materialien der Schicht 1 und Schicht 2 dargestellt, beispielsweise für ZnSe in Schicht 1 und BeTe in Schicht 2. Der energetische Unterschied im Valenzband ΔE_{C} an der Grenzfläche zwischen BeTe und ZnSe kann nach dem in der Diskussion zu Figur 1 bis Figur 4 behandelten Grenzflächenpräparationsverfahren zwischen 1,21 eV und 0,4 eV eingestellt werden. Im günstigen Fall muß also mit dem elektrischen Feld des δ-dotierten Dipols zwischen den Schichten 4 und 5 ein Potentialunterschied von 0,4 eV kompensiert werden. Durch die Möglichkeit, ZnSe bis zu 5·10¹⁹ cm⁻³ n-leitend und BeTe bis zu 10²⁰ cm⁻³ p-leitend dotieren zu können, ergeben sich Flächenladungsdichten in den Schichten 4 und 5 von über 10¹³ cm⁻², die durch δ-Dotierung erzielt werden können. Durch die Reduzierung der Valenzbanddiskontinuität zwischen BeTe und ZnSe von 1,2 eV auf 0,4 eV mit dem erfindungsgemäßen Präparationsverfahren kann die Weite des Ubergangsbereiches mit der digitalen Legierung auf unter 10 nm verringert werden, wie es in Figur 7 angezeigt ist, woraus ein geringerer elektrischer Widerstand der Kontaktstruktur resultiert. Ein weiterer Vorteil dieser erfindungsgemäßen Ausgestaltung liegt darin, daß in den Schichten 6 und 7 der graduellen oder digital graduellen Legierung 3 eine geringere p-Dotierung ausreichend ist, als sie in einer Grading- oder Pseudograding-Kontaktstruktur benötigt wird.
Auf der BeTe-enthaltenden Schicht kann eine ZnTe-enthaltende Schicht abgeschieden sein, die p-leitend und zwischen 1nm und 500nm dick sein kann.

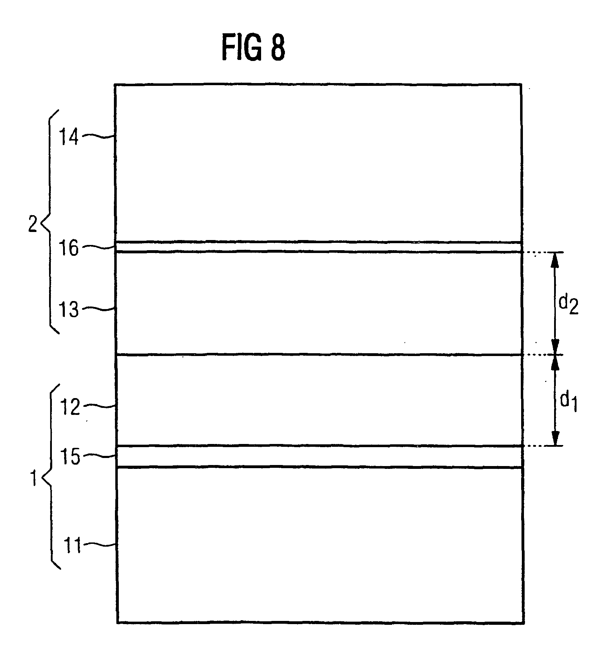

In einer anderen Ausführungsform einer erfindungsgemäßen Kontaktstruktur wird die Grenzfläche zwischen einer ZnSe-enthaltenden Schicht und einer BeTe-enthaltenden Schicht innerhalb zweier gegensätzlich dotierter Schichten, einem sogenannten Dotierungsdipol, platziert, derart, daß auf der Seite der BeTe-enthaltenden Schicht elektronische Zustände in einem Dreieckspotential, das sich durch das interne elektrische Feld des Dipols nahe der Grenzfläche ausbildet, von Löchern besetzt werden können. In diesem energetischen Niveau stehen Löcher beim Übergang in die ZnSe-enthaltende Schicht einer geringeren Barriere gegenüber, als in einer uniform dotierten Schichtenfolge. In Figur 8 ist der Schichtaufbau einer erfindungsgemäßen Kontaktstruktur schematisch dargestellt. Die Grenzfläche zwischen den ZnSe-enthaltenden Schichten 11,12 und den BeTe-enthaltenden Schichten 13,14 kann dabei so präpariert werden, wie es in der Diskussion zu Figur 1 und 2 beschrieben ist. Im Abstand d₁ bzw. d₂ von der Grenzfläche wird eine mit Akzeptoren dotierte Schicht 15 bzw. mit Donatoren dotierte Schicht 16 eingebracht. In einer Ausgestaltung der Kontaktstruktur werden die Abstände d₁ bzw. d₂ gleich groß gewählt, sie können aber auch unterschiedliche Werte annehmen. Der Abstand zur Grenzfläche soll jedoch nicht größer als jeweils 30 nm sein. Die Dicke der δ-dotierten Bereiche 15 und 16 soll zwischen 0,5 und 50 Monolagen betragen. Die Schichten 11, 12, 13 und 14 können undotiert, bevorzugt jedoch p-leitend dotiert sein.

In einer bevorzugten Ausführungform der erfindungsgemäßen Kontaktstruktur wird der stark mit Akzeptoren dotierte Bereich 15 aus einem Tellur-enthaltenden Material, im Speziellen BeTe-enthaltenden Material gebildet, derart, daß die Te-enthaltende Schicht 15 zwischen 0,5 und 5 Monolagen dünn ist und es zu keiner Lokalisation von Löchern in Schicht 15 kommt. Das Einbringen von Donatoren in Schicht 16 kann dadurch erfolgen, daß ein n-dotiertes Selen-enthaltendes Material, im Speziellen ZnSe-enthaltendes Material mit einer Schichtdicke von 0,5 bis 5 Monolagen eingesetzt wird. Auf der BeTe-enthaltenden Schicht kann eine ZnTe-enthaltende Schicht abgeschieden sein, die p-leitend und zwischen 1nm und 500nm dick sein kann.

In Figur 9a ist schematisch das Bänderschema am Übergang zwischen einem ZnSe-enthaltenden Halbleiter (Bereich 1) und einem BeTe-enthaltenden Halbleiter (Bereich 2) dargestellt. In dieser Darstellung müssen Löcher eine Potentialbarriere E_{b} überwinden, um aus dem Valenzband E_{C} von BeTe in das Valenzband von ZnSe zu gelangen. Bei der Präparation der Grenzfläche zu einer Be-Se-Konfiguration, wie es in der Diskussion zu Figur 1 und 2 beschrieben ist, beträgt diese Barriere E_{b}=0,4 eV.

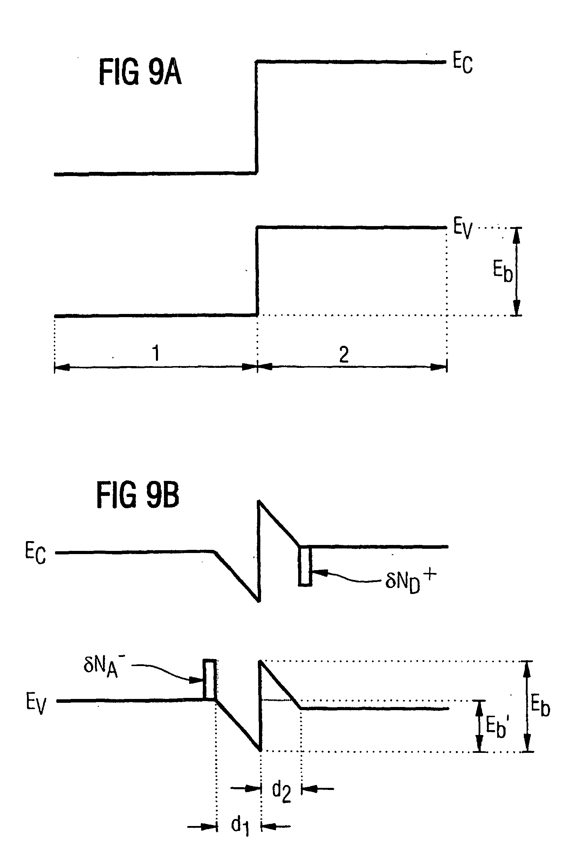

In Figur 9b ist das Bänderschema des gleichen Materialüberganges gezeigt. In dieser Darstellung ist der Einbau eines Dotierungsdipols mit der Weite d₁+d₂ berücksichtigt. Durch das interne elektrische Feld des Dipols kommt es zur Ausbildung eines Dreieckspotentials in der BeTe-enthaltenden Schicht nahe der Grenzfläche. In dieser Potentialmulde können Löcher einen elektronischen Zustand besetzen, von dem aus sie eine geringere Potentialbarriere E_{b}' überwinden müssen, die um den Wert E_{b}-E_{b}'=wδn/ε gegenüber der uniform dotierten Schichtenfolge (Figur 9a) erniedrigt ist, wobei w=d₁+d₂ der Abstand der δ-dotierten Schichten , δn die Flächenladungsdichte an ionisierten Donatoren bzw. Akzeptoren und ε die (gemittelte) Dielektrizitätskonstante des Halbleitermaterials ist.

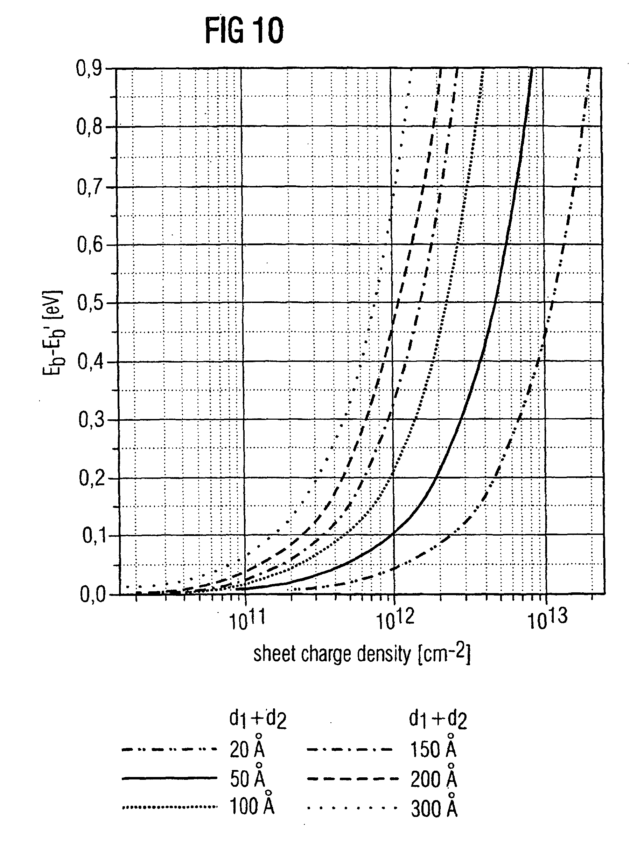

In Figur 10 ist die Barrierenreduktion E_{b}-E_{b}' [eV] als Funktion der Flächenladungsdichte (sheet charge density [cm⁻²] an ionisierten Donatoren und Akzeptoren δn=δp für verschiedene Weiten d₁+d₂ des Dotierungsdipols gezeigt, wobei angenommen wurde, daß d₁ gleich d₂ ist. Für Flächenladungsdichten von beispielsweise 10¹² cm⁻² Akzeptoren und Donatoren kann durch das Einbringen eines Dotierungsdipols mit einer Ausdehnung von d₁+d₂=20 nm bis d₁+d₂=30 nm die Barriere an der Grenzfläche um mehr als 0,4 eV erniedrigt werden, wodurch die Barriere von 0,4 eV zwischen einer BeTe-enthaltenden Schicht und einer ZnSe-enthaltenden Schicht vollständig abgebaut werden kann. Bevorzugt wird eine Flächenladungsdichte, die größer als 5*10¹²cm⁻² ist. Damit können Löcher leicht in die ZnSe-enthaltende Schicht gelangen, womit ein verlustarmer Kontakt gebildet werden kann.

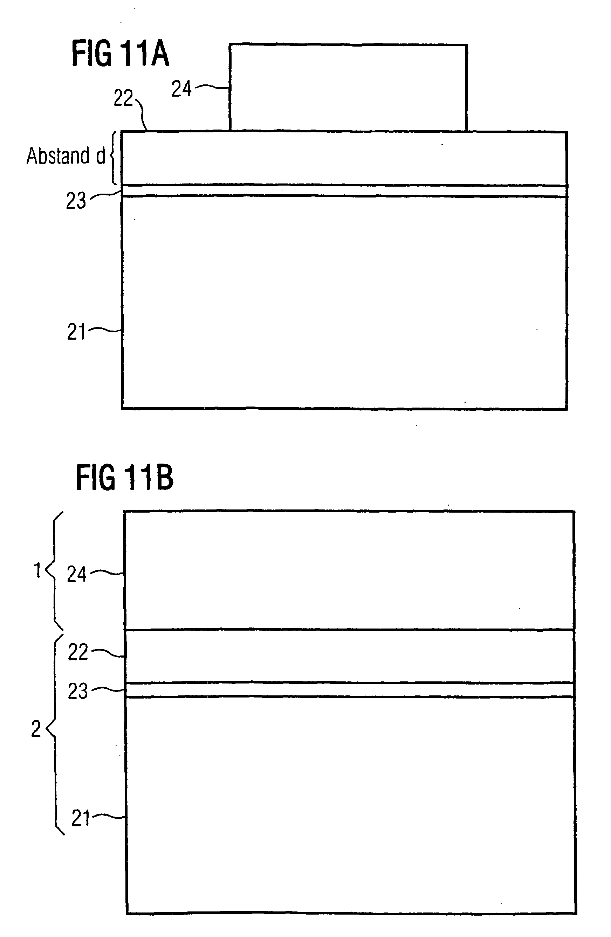

In den Figuren 11a und 11b sind weitere Ausgestaltungen der erfindungsgemäßen Kontaktstruktur zu einem p-leitenden, ZnSe-enthaltenden Halbleitermaterial schematisch dargestellt. In Figur 11a ist der Aufbau eines verlustarmen Metallkontaktes auf einer ZnSe-enthaltenden Schicht abgebildet. Hierbei ist auf der ZnSe-enthaltenden Schicht 21 und 22 ein Metallkontakt 24 abgeschieden. In einem Abstand d von der Grenzfläche zwischen Metallschicht 24 und ZnSe-enthaltender Schicht 22 wird eine Schicht mit erhöhter Akzeptorkonzentration eingebracht, derart, daß die Dicke d der Schicht 22 so klein ist, daß ein ausreichender Tunnelstrom an Löchern vom Metallkontakt in die Schicht 21 fließen kann. Dabei ist darauf zu achten, die Dikke der hochdotierten Schicht 23 klein zu wählen, um Akzeptoren in diesem Bereich vollständig zu ionisieren und keine Lokalisation von Ladungsträgern in dieser Schicht zu ermöglichen.

Im Speziellen kann der Metallkontakt 24 aus mehreren Schichten bestehen, bevorzugt Pd/Pt/Au oder Sb/Au oder andere Metallkombinationen, bei welchen auf p-leitendem ZnSe eine Potentialbarriere kleiner als 1,2 eV entsteht. Die Folge von Metallen wird nach der epitaktischen Herstellung der Schichtfolge 21,23,22 durch Aufdampfen reiner Metalle erzeugt, bevorzugt werden die Metalle direkt nach der Epitaxie noch innerhalb des Ultrahochvakuums aufgebracht. Die Schichten 21 und 22 sind mit Akzeptoren in einer Konzentration zwischen 10¹⁶ und 10¹⁹ cm⁻³ dotiert und p-leitend. Die Dicke d von Schicht 22 sollte zwischen 0,1 nm und 10 nm, bevorzugt weniger als 4 nm betragen.

Die hochdotierte Schicht 23 kann ZnSe enthalten, bevorzugt wird jedoch ein Tellur-enthaltendes Material für Schicht 23. Die hohe Akzeptorkonzentration in einer Te-enthaltenden Schicht, wie sie beispielsweise in Schicht 23 auftritt, kann dadurch erzielt werden, daß Tellur und gleichzeitig der Dotierstoff, oder erst Te und - während einer Wachstumspause - das Akzeptormaterial durch Molekularstrahlen eingebracht wird. Die Dicke der Te-enthaltenden Schicht, in Figur 11a beispielweise Schicht 23, sollte zwischen 0,5 Monolagen (dies kann durch das Angebot von Te und dem Dotierstoff auf einer Zn-bedeckten ZnSe Oberfläche erfolgen, wodurch eine Se-Zn-Te-Zn-Se-Abfolge erzielt wird) und 50 Monolagen betragen. Bei Schichtdicken größer als 0,5 Monolagen kann beispielsweise hochdotiertes BeTe als dotierte Schicht 23 eingebracht werden, wobei bevorzugt die BeTe-Schichtdicke zwischen einer und fünf Monolagen gewählt wird. Dabei ist es vorteilhaft, wenn die Grenzflächen zwischen Schicht 21 und 23 bzw. zwischen Schicht 23 und 22 so präpariert werden, daß eine Be-Se-Konfiguration entsteht, wie es in der Diskussion zu Figur 1 und 2 beschrieben ist. Als Akzeptoren können beispielsweise plasmaaktivierter Stickstoff oder As, Sb, P oder andere Elemente der I. und/oder V. und/oder IV. Hauptgruppe des Periodensystems eingesetzt werden.

In Figur 11b ist eine schematische Darstellung einer Kontakt- bzw. Übergangsstruktur dargestellt, die im Unterschied zu dem in Figur 11a gezeigten Aufbau keinen Übergang zu einem Metall, sondern den Übergang zwischen einer ZnSe-enthaltenden Schicht 21,22 auf eine Te-enthaltende Schicht 24 beschreibt. Die allgemeinen und speziellen Merkmale der Schichten 21,22 und 23 sind der Beschreibung zu Figur 11a zu entnehmen. Schicht 24 besteht beispielsweise aus einem BeTe oder ZnTeenthaltenden Material, das epitaktisch auf Schicht 22 aufgebracht ist.

In einer bevorzugten Ausführung wird das Material in Schicht 24 hoch p-leitend dotiert, im Speziellen ist die Akzeptorkonzentration in Schicht 24 höher als 10¹⁸ cm⁻³ oder Schicht 24 ist entartet dotiert. Die Grenzfläche zwischen Schicht 22 und Schicht 24 ist in einer Be-Se-Konfiguration präpariert, so daß eine niedrige Potentialbarriere für Löcher entsteht. Die Grenzfläche kann stark mit Selen terminiert sein, so daß beim Wachstum der BeTe-enthaltenden Schicht elektronische Zustände innerhalb des verbotenen Bandes am Materialübergang entstehen und es so zu einem Fermi-Level-Pinning an der Grenzfläche kommen kann.

Auf der BeTe-enthaltenden Schicht kann eine ZnTe-enthaltende Schicht abgeschieden sein, die p-leitend und zwischen 1nm und 500nm dick sein kann.

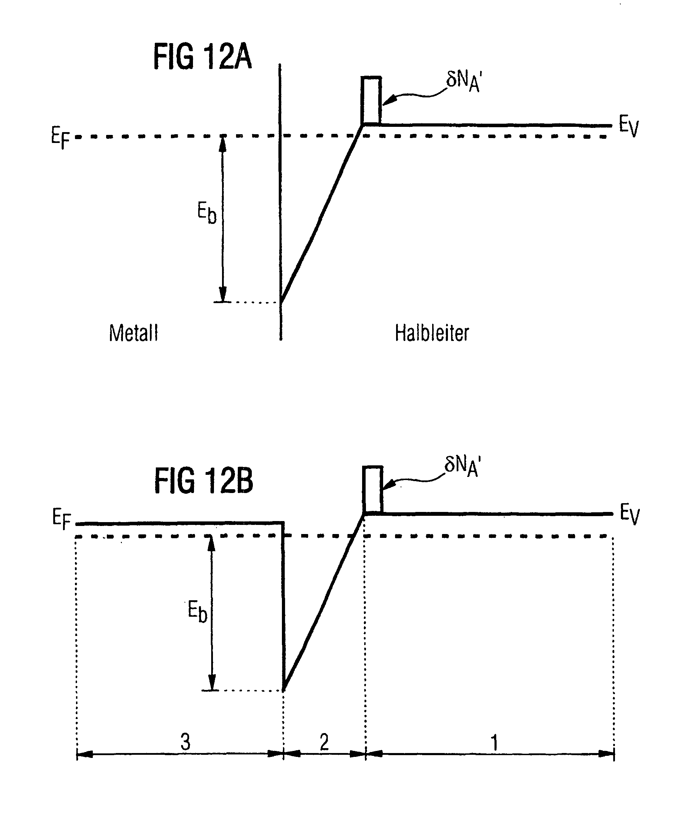

Die Figuren 12a und 12b zeigen das vereinfachte Bänderschema der Kontaktstrukturen aus Figur 11a bzw. 11b. In diesen Darstellungen ist der Bereich nahe der Grenzfläche zwischen einem Metall und einer ZnSe-enthaltenden Schicht (Figur 12a) bzw. der Bereich nahe der Grenzfläche zwischen einem BeTe-enthaltenden Material 23 und einem ZnSe-enthaltenden Material 21,22 (Figur 12b) unter Einbeziehung einer dünnen, stark mit Akzeptoren dotierten Schicht gezeigt. Durch die hohe Akzeptorenkonzentration in der hochdotierten Schicht (in Figur 12a und 12b sind Akzeptorzustände mit einer hohen Dichte δN_{A}⁻ nahe der Valenzbandkante durch ein graues Feld angedeutet) wird das Fermi-Niveau E_{F} im Halbleiter in das Valenzband gebracht. Die verbleibende Potentialbarriere E_{b} kann von Löchern durchtunnelt werden, falls die Dicke der Tunnelbarriere (Bereich 22 in Figur 12b) klein ist.

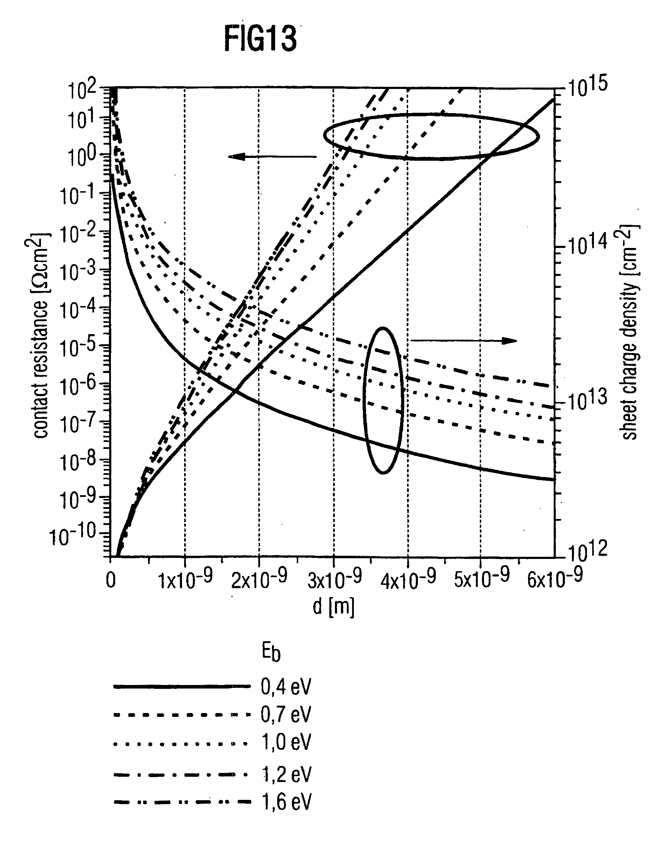

Die minimale Flächenladungsdichte in Schicht 23 (Figur 11a und 11b) kann mit δp=δN_{A}⁻≥(εE_{b})/(ed) angegeben werden. Die Abhängigkeit zwischen dem Abstand d [m] der hochdotierten Schicht 23, wie sie in den Ausgestaltungen gemäß Figur 11a und 11b beinhaltet ist, und der Flächendotierung δp an Akzeptoren (Flächenladungsdichte = sheet charge density [cm⁻²]) in der hochdotierten Schicht 23 ist in Figur 13 dargestellt. In den Berechnungen zu Figur 13 wurde ε/ε₀=8,5 und die effektive Masse der Löcher zu m*/m₀=0,7 angesetzt. Bevorzugt werden möglichst geringe Abstände d, da auf diese Weise der Kontaktwiderstand stark reduziert werden kann. Eine Abschätzung des Kontaktwiderstandes (contact resistance [Ωcm⁻²]) ist ebenfalls in Figur 13 dargestellt.

In einer beispielhaften Ausgestaltung der erfindungsgemäßen Kontaktstruktur gemäß Figur 11a oder 11b wird nach dem Zusammenhang, der in Figur 13 gezeigt ist, für einen Abstand d=3 nm und eine Potentialbarriere E_{b}=0,4eV eine Flächendotierung von mehr als 5·10¹² cm⁻² in Schicht 23 eingefügt. Im Abstand d=1 nm werden ca. 2·10¹³ cm⁻² Flächenladungen benötigt, was mit δ-Dotierung von Te-enthaltenden Materialien, insbesondere von BeTe in Schicht 3 erzielt werden kann.

Die Abschätzung für den Kontaktwiderstand in Tunnelstrukturen gemäß Figur 12b ist in Figur 13 für verschiedene Werte der Potentialbarriere für Löcher angegeben. Durch die Reduzierung des Valenzbandsprunges zwischen einem BeTe-enthaltenden und einem ZnSe-enthaltenden Material von 1,2 eV auf ca. 0,4 eV kann der Kontaktwiderstand deutlich reduziert werden, wobei zu bemerken ist, daß niedrige Kontaktwiderstände nur für geringe Potentialbarrieren bei Abständen d kleiner ca. 3,5 nm zu erwarten sind. In diesem Bereich sind Flächenladungsdichten von über 5*10¹² cm⁻² notwendig. Bei üblichen Potentialbarrieren über 1,2 eV sind sehr viel höhere Flächenladungsdichten. notwendig, die mit den eingesetzten Materialien nicht zu erzielen sind.

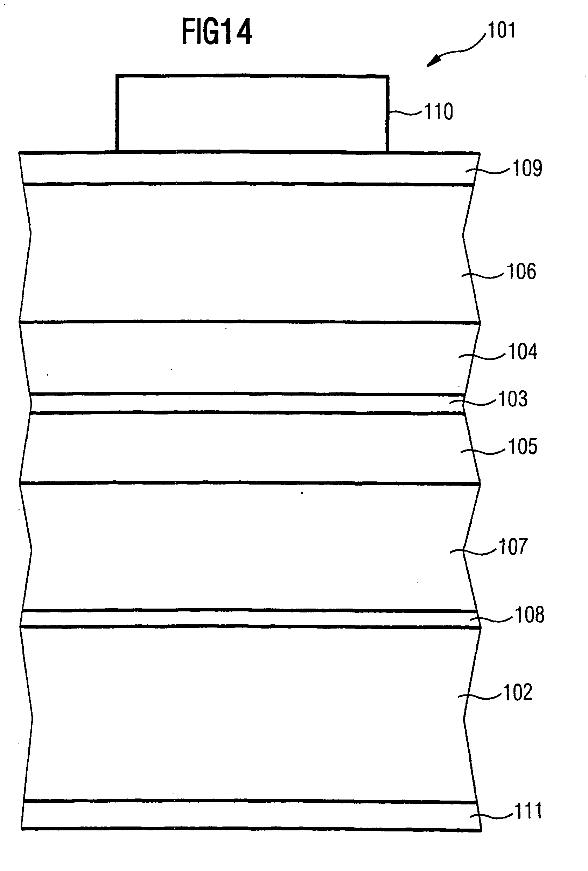

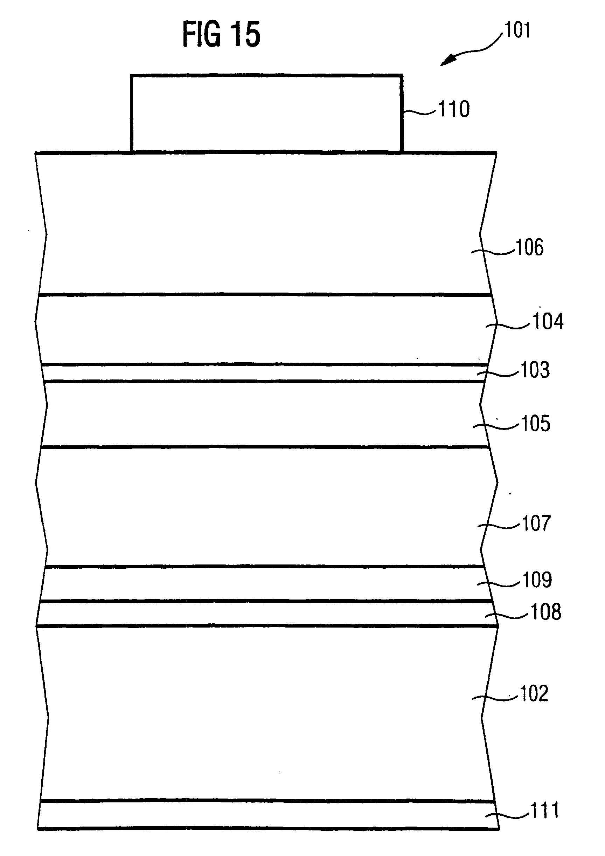

Der Einsatz der beschriebenen Ausgestaltungen erfindungsgemäßer Kontaktstrukturen in optoelektronischen Bauelementen aus II-VI Halbleitern ist in Figur 14 und Figur 15 beispielhaft anhand des Schichtaufbaus zweier Laser- oder Leuchtdioden dargestellt.

In Figur 14 ist ein Halbleiterkörper 101 gezeigt, bei welchem auf einem Halbleitersubstrat 102 eine zur Lichterzeugung geeignete Bauelementstruktur aufgebracht ist, die aus einer aktiven Zone 103 besteht, welche als Quantentrog (QW) oder Übergitter (SL) oder Vielfachquantentrog (MQW) oder Quantenpunktstruktur ausgebildet sein kann. Diese aktive Zone ist in Halbleiterbarriereschichten 104 (mit erstem Leitungstyp) und 105 (mit zweitem Leitungstyp) eingebettet, die eine größere Bandlücke besitzen als die aktive Schicht 103. An die Schichtfolge 105,103,104 grenzt eine Mantelschicht 106 vom ersten Leitungstyp und eine Mantelschicht 107 mit zweitem Leitungstyp an, die beide einen geringeren Brechungsindex besitzen als die Schichten 103,104 und 105. Diese Bauelementstruktur ist über eine Pufferschicht 108 an das Substrat 102 mit zweitem Leitungstyp angeschlossen. An der dem Substrat 102 gegenüberliegenden Seite der aktiven Zone 103 ist auf der äußeren Mantelschicht 106 vom ersten Leitungstyp eine Kontaktschicht 109 angeordnet. Der elektrische Anschluß kann über einen an der Oberfläche von Schicht 109 liegenden Metallkontakt 110 und einen beispielsweise an der Rückseite des Substrates 102 angeordneten Metallkontakt 111 erfolgen.

Erfindungsgemäß ist vorgesehen, die Kontaktschicht 109, die auf der oberen Mantelschicht 106 aufgebracht ist, als Mehrfachschicht auszugestalten, die insbesondere ZnSe-enthaltende und BeTe-enthaltende Materialien beinhaltet. Als Merkmale des Aufbaus von Schicht 109 sind die Merkmale der erfindungsgemäßen Kontaktstrukturen, wie sie in der Diskussion zu den Ausgestaltungen gemäß den Figuren 5a, 5b, 8, 11a und 11b und den zugeordneten Figuren angegeben sind.
Bei der Verwendung der Kontaktschicht 109 auf einer p-leitenden Mantelschicht 106, die insbesondere Selen oder ZnSe enthält, wird in der erfindungsgemäßen Kontaktschichtfolge 109 die ZnSe-enthaltende Basisschicht innerhalb der Schicht-. folge von Schicht 109 der Mantelschicht 106 zugewandt und die Tellur oder BeTe-enthaltende Kontaktschicht dem Metallkontakt 110 zugewandt.

In einer bevorzugten Ausgestaltung des Halbleiterkörpers 101 aus Figur 14 besteht das Substrat 102 aus n-leitendem GaAs auf dem ein n-leitender GaAs oder InGaAs-Puffer 108 mit MBE aufgebracht ist. Die aktive Zone 103 ist zwischen 50 nm und 1,5 nm breit und besteht beispielsweise aus BeZnCdSe, ZnCdSSe oder einem ZnSe/BeTe Übergitter mit einer vorgegebenen Periode von weniger als 10 nm, bei dem durch die Wahl der einzelnen Schichtdicken von ZnSe und BeTe die Emissionswellenlänge der Laser- oder Leuchtdiode eingestellt werden kann. Die aktive Zone kann auch als Quantenpunktstruktur mit beispielsweise CdSe-enthaltenden Quantenpunkten in einer ZnSe- oder BeMgZnSe-Matrix oder einem anderen Material ausgebildet sein. Als Wellenleiterschichten 104, 105 (Dicke ca. 20nm bis 200nm) kann BeZnSe oder ZnSSe verwendet werden, in der Art, daß die Gitterfehlanpassung des Mischkristalls in Schicht 104 und 105 kleiner als 0,1% zum Substratkristall ist. In Schicht 106 und 107 kann beispielsweise BeMgZnSe oder ZnMgSSe oder ein BeMgZnSe/BeTe, ZnMgSSe/ZnSe oder ein BeMgZnSe/ZnSe Übergitter mit vorgegebener Periode eingesetzt werden, in der Art, daß die Gitteranpassung des Mischkristalls in Schicht 106 und 107 kleiner als 0,1% zum Substratkristall ist. Zur p-Dotierung der Schichten 104, 106 und 109 kann beispielsweise plasmaaktivierter Stickstoff eingesetzt werden. Als Donatoren in den Schichten 105 und 107 kann beispielsweise I, Cl, Br oder Al verwendet werden. Schicht 108 kann z.B. mit Si n-leitend dotiert sein. Der Metallkontakt 110 kann aus Pd/Pt/Au , Kontakt 111 kann beispielsweise aus Au/Ge oder In bestehen.

In Figur 15 ist ein Halbleiterkörper 101 gezeigt, bei welchem auf einem Halbleitersubstrat 102 eine zur Lichterzeugung geeignete Bauelementstruktur aufgebracht ist, die aus einer aktiven Zone 103 besteht, welche als Quantentrog oder Übergitter oder Vielfachquantentrog oder als Quantenpunktstruktur ausgebildet sein kann. Diese aktive Zone ist in Halbleiterbarriereschichten 104 (mit zweitem Leitungstyp) und 105 (mit erstem Leitungstyp) eingebettet, die eine größere Bandlücke besitzen als die aktive Schicht 103. An die Schichtfolge 105,103,104 grenzt eine Mantelschicht 106 vom zweiten Leitungstyp und eine Mantelschicht 107 mit erstem Leitungstyp an, die beide einen geringeren Brechungsindex besitzen als die Schichten 103,104 und 105. Diese Bauelementstruktur ist über eine Pufferschicht 108 an das Substrat 102 mit erstem Leitungstyp angeschlossen. An das Substrat 102 angrenzend ist zwischen Substrat und einer Mantelschicht 107 vom ersten Leitungstyp eine Kontaktschicht 109 angeordnet. Der elektrische Anschluß kann über einen an der Oberfläche von Schicht 106 oder auf einer Kontaktschicht liegenden Metallkontakt 110 und einen beispielsweise an der Rückseite des Substrates 102 angeordneten Metallkontakt 111 erfolgen.

Erfindungsgemäß ist vorgesehen, die Kontaktschicht 109, die zwischen dem Substrat 102 oder der Pufferschicht 108 und der Mantelschicht 107 angeordnet ist, als Mehrfachschicht auszugestalten, die insbesondere ZnSe-enthaltende und BeTe-enthaltende Materialien beinhaltet. Als Merkmale des Aufbaus von Schicht 109 sind die Merkmale der erfindungsgemäßen Kontaktstrukturen, wie sie in der Diskussion zu den Ausgestaltungen gemäß den Figuren 5a, 5b, 8, 11a und 11b und den zugeordneten Figuren angegeben sind.

Bei der Verwendung der Kontaktschicht 109 zwischen einem p-leitenden Substrat 102 und einer p-leitenden Mantelschicht 107, die insbesondere Selen oder ZnSe enthält, wird in der erfindungsgemäßen Kontaktschichtfolge 109 die ZnSe-enthaltende Basisschicht innerhalb der Schichtfolge von Schicht 109 der Mantelschicht 107 zugewandt und die Tellur oder BeTe-enthaltende Kontaktschicht dem p-leitenden Substrat 102 oder der Pufferschicht 108 zugewandt.

In einer bevorzugten Ausgestaltung des Halbleiterkörpers 101 aus Figur 15 besteht das Substrat 102 aus p-leitendem GaAs auf dem ein p-leitender GaAs- oder InGaAs-Puffer 108 mit MBE aufgebracht ist. Die aktive Zone 103 ist zwischen 50 nm und 1,5 nm breit und besteht beispielsweise aus BeZnCdSe, ZnCdSSe oder einem ZnSe/BeTe Übergitter mit einer vorgegebenr Periode von weniger als 10 nm, bei dem durch die Wahl der einzelnen Schichtdicken von ZnSe und BeTe die Emissionswellenlänge der Laser- oder Leuchtdiode eingestellt werden kann. Als Wellenleiterschichten 104, 105 (Dicke ca. 20nm bis 200nm) kann BeZnSe oder ZnSSe verwendet werden, in der Art, daß die Gitterfehlanpassung des Mischkristalls in Schicht 104 und 105 kleiner als 0,1% zum Substratkristall ist. In Schicht 106 und 107 kann beispielsweise BeMgZnSe oder ZnMgSSe oder ein BeMgZnSe/BeTe, ZnMgSSe/ZnSe oder ein BeMgZnSe/ZnSe Übergitter mit vorgegebener Periode eingesetzt werden, in der Art, daß die Gitterfehlanpassung des Mischkristalls in Schicht 106 und 107 kleiner als 0,1% zum Substratkristall ist. Zur p-Dotierung der Schichten 105,107 und 109 kann beispielsweise plasmaaktivierter Stickstoff eingesetzt werden. Als Donatoren in den Schichten 104 und 106 kann beispielsweise I, Cl, Br oder Al verwendet werden. Schicht 108 kann z.B. mit Si n-leitend dotiert sein. Der Metallkontakt 110 kann aus Ti/Pt/Au oder Al, Kontakt 111 kann beispielsweise aus Au/Zn oder In bestehen.

Die Beschreibung der Art und Weise der erfindungsgemäßen Grenzflächenpräparation bzw. der Art und Funktion der einzelnen Schichten in Zusammenhang mit den erfindungsgemäßen Kontaktstrukturen und Bauelementen anhand dieser Ausführungsbeispiele ist selbstverständlich nicht als Beschränkung der Erfindung auf diese Ausführungsbeispiele zu verstehen. Erfindungsgemäße Kontaktstrukturen können in Emitter-, Detektor-, in aktiven und passiven Bauelementen mit mehrpoliger Ansteuerung aus II-VI Halbleitern auf Substraten aus II-VI, III-V und Elementhalbleitern, wie beispielsweise ZnSe, CdZnTe, CdTe, GaAs, InAs, GaP, Si, Ge und anderen ausgebildet sein. Dabei kann eine erfindungsgemäße Kontaktschichtfolge zur Ausbildung eines der Oberfläche zugewandten ohmschen Kontaktes aber auch zum elektrischen Anschluß eines Bauelementes an ein leitendes oder nichtleitendes Substrat dienen. Erfindungsgemäße Kontaktstrukturen können auch zum Übergang von II-VI Halbleiterschichten auf der Basis von CdTe, CdSe, MnTe, MgTe, ZnTe, BeTe, ZnS, BeS, BeSe und ZnSe, ZnO, SrSe, BaSe, SrTe, BaTe, SrS, BaS-enthaltenden Schichten dienen.

## Patentansprüche

1. II-VI-Halbleiter-Bauelement (101), bei dem innerhalb einer Schichtenfolge (109) mindestens ein Übergang von einer BeTe-enthaltenden Halbleiterschicht (2) auf eine Se-enthaltende Halbleiterschicht (1) vorhanden ist, **dadurch gekennzeichnet, daß** eine Grenzfläche zwischen der BeTe-enthaltenden (2) und der Se-enthaltenden Halbleiterschicht (1) derart präpariert ist, daß eine Be-Se-Bindungskonfiguration ausgebildet ist.

2. II-VI-Halbleiter-Bauelement nach Anspruch 1, bei dem die Potentialbarriere für Löcher kleiner als 0,4 eV beträgt.

3. II-VI-Halbleiter-Bauelement nach Anspruch 1 oder 2, bei dem zwischen der Se-enthaltenden Schicht (1) und der BeTe-enthaltenden Schicht (2) eine Übergangsschicht (3) eingebracht ist, die aus einer Legierung mit gradueller Änderung der Zusammensetzung besteht, wobei die Zusammensetzung der Legierung von der Zusammensetzung der Se-enthaltenden Schicht (1) graduell auf die Zusammensetzung der BeTe-enthaltenden Schicht (2) geändert wird.

4. II-VI-Halbleiter-Bauelement nach Anspruch 3, bei dem die graduelle Legierung als digitale graduelle Legierung (6,7) ausgebildet ist.

5. II-VI-Halbleiter-Bauelement nach Anspruch 3 oder 4, bei dem zwischen der Se-enthaltenden Schicht (1) und der graduellen bzw. digitalen graduellen Legierung mindestens eine mit Akzeptoren delta-dotierte Schicht (4) eingefügt ist.

6. II-VI-Halbleiter-Bauelement nach einem der Ansprüche 3 bis 5, bei dem zwischen der graduellen bzw. digitalen graduellen Legierung und der BeTe-enthaltenden Schicht (2) mindestens eine mit Donatoren delta-dotierte Schicht (5) eingebracht ist.

7. II-VI-Halbleiter-Bauelement nach einem der Ansprüche 1 bis 6, bei der in der Se-enthaltenden Schicht (1) in einem Abstand zur Grenzfläche zwischen der BeTe-enthaltenden Schicht (2) und der Se-enthaltenden Schicht (1) mindestens eine mit Akzeptoren dotierte Schicht (15) eingefügt ist.

8. II-VI-Halbleiter-Bauelement nach einem der Ansprüche 1 bis 7, bei der in der BeTe-enthaltenden Schicht (2) in einem Abstand zur Grenzfläche zwischen der BeTe-enthaltenden Schicht (2) und der Se-enthaltenden Schicht (1) mindestens eine mit Donatoren dotierte Schicht (16) eingefügt ist.

9. Verfahren zur Herstellung des II-VI-Halbleiter-Bauelements gemäß einem der Ansprüche 1 bis 8, bei dem beim epitaktischen Wachstum der Se-enthaltenden Schicht mit einer Se-Bedeckung aufgehört bzw. begonnen wird und/oder das Wachstum der Se-enthaltenden Schicht unter Se-reichen Bedingungen erfolgt.

10. Verfahren nach Anspruch 9, bei dem vor dem Wachstum der BeTe-enthaltenden Schicht auf die Oberfläche der Se-enthaltenden Schicht ein Se-Fluß gegeben wird.

11. Verfahren gemäß Anspruch 9, bei dem die Be-Se-Konfiguration dadurch präpariert wird, daß das Wachstum der Se-enthaltenden Schicht unter Überschuß an Se stattfindet.

## Claims

1. II-VI semiconductor component (101), in which there is at least one junction between a semiconductor layer (2) containing BeTe and a semiconductor layer (1) containing Se within a layer sequence (109), **characterized in that** an interface between the semiconductor layer (2) containing BeTe and the semiconductor layer (1) containing Se is prepared in such a way that a BeSe bond configuration is formed.

2. II-VI semiconductor component according to Claim 1, in which the potential barrier for holes is less than 0.4eV.

3. II-VI semiconductor component according to Claim 1 or 2, in which a junction layer (3), which consists of an alloy with graded variation in composition, is placed between the layer (1) containing Se and the layer (2) containing BeTe, the composition of the alloy being varied in a graded manner from the composition of the layer (1) containing Se to the composition of the layer (2) containing BeTe.

4. II-VI semiconductor component according to Claim 3, in which the graded alloy is formed as a digital graded alloy (6, 7).

5. II-VI semiconductor component according to Claim 3 or 4, in which at least one layer (4) delta-doped with acceptors is inserted between the layer (1) containing Se and the graded or digital graded alloy.

6. II-VI semiconductor component according to one of Claims 3 to 5, in which at least one layer (5) delta-doped with donors is placed between the graded or digital graded alloy and the layer (2) containing BeTe.

7. II-VI semiconductor component according to one of Claims 1 to 6, in which at least one layer (15) doped with acceptors is inserted in the layer (1) containing Se, at a distance from the interface between the layer (2) containing BeTe and the layer (1) containing Se.

8. II-VI semiconductor component according to one of Claims 1 to 7, in which at least one layer (16) doped with donors is inserted in the layer (2) containing BeTe, at a distance from the interface between the layer (2) containing BeTe and the layer (1) containing Se.

9. Process for producing the II-VI semiconductor component according to one of Claims 1 to 8, in which the epitaxial growth of the layer containing Se ends or starts with Se coverage and/or the layer containing Se is grown under Serich conditions.

10. Process according to Claim 9, in which an Se flux is applied to the surface of the layer containing Se before the growth of the layer containing BeTe.

11. Process according to Claim 9, in which the BeSe configuration is prepared by growing the layer containing Se under excess Se.

## Revendications

1. Elément de construction de semi-conducteur II-VI (101), pour lequel il existe, à l'intérieur d'une suite de couches (109), au moins une jonction d'une couche de semi-conducteur contenant du BeTe (2) vers une couche de semi-conducteur contenant du Se(1), **caractérisé en ce qu'**une surface limite entre la couche de semi-conducteur contenant du BeTe (2) et la couche de semi-conducteur contenant du Se (1) est préparée de manière à ce qu'une configuration de liaison Be-Se soit formée.

2. Elément de construction de semi-conducteur II-VI selon la revendication 1, pour lequel le seuil de potentiel pour des lacunes est plus petit que 0,4 eV.

3. Elément de construction de semi-conducteur II-VI selon l'une quelconque des revendications 1 ou 2, pour lequel une couche de jonction (3) est aménagée entre la couche contenant du Se (1) et la couche contenant du BeTe (2), laquelle se compose d'un alliage avec une modification progressive de la composition, moyennant quoi la composition de l'alliage est modifiée de manière progressive pour passer de la composition de la couche contenant du Se (1) à la composition de la couche contenant du BeTe (2).

4. Elément de construction de semi-conducteur II-VI selon la revendication 3, pour lequel l'alliage progressif est développé sous la forme d'un alliage progressif digital (6, 7).

5. Elément de construction de semi-conducteur II-VI selon l'une quelconque des revendications 3 ou 4, pour lequel entre la couche contenant du Se (1) et l'alliage progressif ou progressif digital, au moins une couche (4) dopée en delta par des accepteurs est insérée.

6. Elément de construction de semi-conducteur II-VI selon l'une quelconque des revendications 3 à 5, pour lequel entre l'alliage progressif ou progressif digital et la couche contenant du BeTe (2), au moins une couche (5) dopée en delta par des donneurs est insérée.

7. Elément de construction de semi-conducteur II-VI selon l'une quelconque des revendications 1 à 6, pour lequel, dans la couche contenant du Se (1) et à une distance par rapport à la surface limite entre la couche contenant du BeTe (2) et la couche contenant du Se (1), au moins une couche (15) dopée par des accepteurs est insérée.

8. Elément de construction de semi-conducteur II-VI selon l'une quelconque des revendications 1 à 7, pour lequel, dans la couche contenant du BeTe (2) et à une distance par rapport à la surface limite entre la couche contenant du BeTe (2) et la couche contenant du Se (1), au moins une couche (16) dopée par des donneurs est insérée.

9. Procédé pour la fabrication de l'élément de construction de semi-conducteur II-VI selon l'une quelconque des revendications 1 à 8, avec lequel l'on termine et/ou débute avec une couverture Se lors de la croissance épitaxiale de la couche contenant du Se et/ou avec lequel la croissance de la couche contenant du Se s'effectue sous des conditions riches en Se.

10. Procédé selon la revendication 9, avec lequel, avant la croissance de la couche contenant du BeTe, un flux de Se est donné sur la surface de la couche contenant du Se.

11. Procédé selon la revendication 9, avec lequel la configuration Be-Se est préparée en ce que la croissance de la couche contenant du Se s'effectue avec un excédent en Se.
